# EUROPÄISCHE PATENTANMELDUNG

(11) **EP 4 660 730 A1**
(43) Veröffentlichungstag der Anmeldung: **10.12.2025**
(21) Anmeldenummer: 25158998.2
(22) Anmeldetag: 20.02.2025
(51) Int. Cl.: G05B 19/418

(54) **COMPUTER-IMPLEMENTIERTES VERFAHREN ZUM ERZEUGEN EINER DIGITALEN STATISCHEN VERSUCHSPLANUNG**

(30) Priorität: 07.06.2024 DE 102024115905
(71) Anmelder: Krones AG, 93073 Neutraubling (DE)
(72) Erfinder: BOETTCHER, Benedikt, 93073 Neutraubling (DE); KRAUSE, Ilona, 93073 Neutraubling (DE)
(74) Vertreter: Grünecker Patent- und Rechtsanwälte PartG mbB

(57) **Zusammenfassung**

Computer-implementiertes Verfahren zum Erzeugen einer digitalen statischen Versuchsplanung, SVP, einer Behälterbehandlungsmaschine, wobei die digitale SVP einen Wert eines Betriebsparameters der Behälterbehandlungsmaschine basierend auf einem SollWert einer charakteristischen Größe eines zu behandelnden Behälters vorhersagen kann, das Verfahren umfassend:
- Erlangen einer Parameter-Trägheit für Betriebsparameter der Behälterbehandlungsmaschine;
- Betreiben der Behälterbehandlungsmaschine mit einem festen Betriebsparameter-Wert eines ersten Betriebsparameters mit einer ersten Parameter-Trägheit und Variieren wenigstens eines zweiten Betriebsparameters mit einer kleineren zweiten Parameter-Trägheit als der ersten Parameter-Trägheit;
- Bestimmen wenigstens einer charakteristischen Größe eines behandelten Behälters abhängig von dem Betriebsparameter-Wert des ersten Betriebsparameters und den Betriebsparameter-Werten des zweiten Betriebsparameters;
- Erzeugen der digitalen SVP basierend auf den Betriebsparameter-Werten und der charakteristischen Größe.

## Beschreibung

Die vorliegende Erfindung betrifft ein Computer-implementiertes Verfahren zum Erzeugen einer digitalen statischen Versuchsanordnung, SVP, eine Behälterbehandlungsmaschine, entsprechend unabhängigem Anspruch 1 sowie ein Verfahren zum Behandeln eines Behälters mit einer Behälterbehandlungsmaschine entsprechend unabhängigem Anspruch 14 und eine Behälterbehandlungsmaschine zum Behandeln eines Behälters entsprechend unabhängigem Anspruch 15.

### Stand der Technik

Digitale statische Versuchsplanungen, SVP, für Maschinen sind aus dem Stand der Technik grundsätzlich bekannt. Diese werden auch als Design of Experiment (DoE) bezeichnet und werden üblicherweise genutzt, um basierend auf gewünschten Produktionsergebnissen, insbesondere Soll-Werten im Zusammenhang mit hergestellten Produkten, die Betriebsparameter einer Maschine so einzustellen, dass das gewünschte Produktionsergebnis möglichst zuverlässig und mit möglichst geringen Abweichungen erreicht wird.

Beispielsweise kann mittels einer digitalen SVP ein Blasformprozess einer Blasformmaschine so gesteuert werden, dass mit den verwendeten Betriebsparameter ein bestimmter Transmissionsgrad oder Reflexionsgrad des hergestellten Behälters realisiert werden kann.

Es ist bekannt, dass eine solche digitale SVP zunächst basierend auf einem Betrieb der entsprechenden Maschine, wie insbesondere einer Behälterbehandlungsmaschine, mit variierenden Betriebsparametern und daraus abgeleiteten charakteristischen Größen der mit diesen Betriebsparametern hergestellten Behälter erzeugt werden muss.

Dies ist jedoch zeitaufwendig, da die Dynamik der Behälterbehandlungsmaschine auf die Veränderungen verschiedener Betriebsparameter unterschiedlich reagiert.

### Aufgabe

Ausgehend vom bekannten Stand der Technik besteht die zu lösende technische Aufgabe somit darin, ein computer-implementiertes Verfahren zum Erzeugen einer digitalen statischen Versuchsplanung, SVP, einer Behälterbehandlungsmaschine anzugeben, mit dem die digitale SVP bei kürzere Betriebsdauer der Behälterbehandlungsmaschine, aber mit gleichbleibend hoher Qualität erzeugt werden kann.

### Lösung

Diese Aufgabe wird erfindungsgemäß durch das computer-implementierte Verfahren zum Erzeugen einer digitalen statischen Versuchsplanung, SVP, entsprechend unabhängigem Anspruch 1 sowie das Verfahren zum Behandeln eines Behälters mit einer Behälterbehandlungsmaschine entsprechend unabhängigem Anspruch 14 und die Behälterbehandlungsmaschine zum Behandeln eines Behälters gemäß unabhängigem Anspruch 15 gelöst. Vorteilhafte Weiterbildungen der Erfindung sind in den Unteransprüchen erfasst.

Das erfindungsgemäße computer-implementierte Verfahren zum Erzeugen einer digitalen statischen Versuchsplanung, SVP, einer Behälterbehandlungsmaschine, wobei die digitale SVP einen Wert eines Betriebsparameters der Behälterbehandlungsmaschine basierend auf einem Soll-Wert einer charakteristischen Größe eines zu behandelnden Behälters vorhersagen kann, umfasst:
- Erlangen einer Parameter-Trägheit für Betriebsparameter der Behälterbehandlungsmaschine;
- Betreiben der Behälterbehandlungsmaschine mit einem festen Betriebsparameter-Wert eines ersten Betriebsparameters mit einer ersten Parameter-Trägheit und Variieren wenigstens eines zweiten Betriebsparameters mit einer kleineren zweiten Parameter-Trägheit als der ersten Parameter-Trägheit;
- Bestimmen wenigstens einer charakteristischen Größe eines behandelten Behälters abhängig von dem Betriebsparameter-Wert des ersten Betriebsparameters und den Betriebsparameter-Werten des zweiten Betriebsparameters;
- Erzeugen der digitalen SVP basierend auf den Betriebsparameter-Werten und der charakteristischen Größe.

Das computer-implementierte Verfahren ist als ein solches Verfahren zu verstehen, das zumindest teilweise innerhalb eines Computers oder durch diesen durchgeführt wird, insbesondere beim Erstellen der digitalen SVP. Jedoch können ein oder mehrere Schritte auch physisch durchgeführt werden. Dies gilt insbesondere für den Schritt des Betreibens der Behälterbehandlungsmaschine mit den gewählten Betriebsparameter-Werten (im Folgenden auch Parameterwerte oder kurz Betriebsparameter). Da zum Erstellen der digitalen SVP das Erzeugen bzw. Behandeln von Behältern erforderlich ist, um für die gewählten Parameterwerte der Betriebsparameter die tatsächlich erhaltenen charakteristischen Werte zu ermitteln und basierend hierauf die digitale SVP zu erzeugen, muss üblicherweise ein tatsächlicher physischer Betrieb der Behälterbehandlungsmaschine erfolgen.

Insofern kann das computer-implementierte Verfahren auch als ein allgemeines Verfahren verstanden werden, bei dem zumindest einige Schritte innerhalb eines Computers erfolgen bzw. ausgeführt werden.

Während die digitale SVP geeignet ist, einen Wert eines Betriebsparameters der Behälterbehandlungsmaschine basierend auf einem Soll-Wert einer charakteristischen Größe eines zu behandelnden Behälters vorherzusagen, versteht es sich, dass erfindungsgemäß auch die Umkehrung mit umfasst ist. Die digitale SVP kann also auch genutzt werden bzw. ist geeignet, basierend auf einer gegebenen Kombination von Betriebsparametern den Wert einer charakteristischen Größe eines zu behandelnden Behälters vorherzusagen.

Unter dem Begriff der Parameter-Trägheit ist allgemein die Trägheit oder Verzögerung der Antwort der Behälterbehandlungsmaschine auf eine Veränderung des Parameterwertes des betreffenden Betriebsparameters zu verstehen. Diese kann abhängig von den Gegebenheiten der Behälterbehandlungsmaschine und den Betriebsparameter unterschiedlich ausfallen. Insbesondere kann die Zeit, die notwendig ist, damit die Behälterbehandlungsmaschine bei Veränderung des betreffenden Betriebsparameters wieder einen stabilen Zustand annimmt, variieren. Die notwendige Zeit für das Einnehmen eines solchen stabilen Zustands hängt dabei von dem Betriebsparameter und dem Verhalten der Behälterbehandlungsmaschine bei Veränderung desselben ab.

Ist der Betriebsparameter beispielsweise eine Temperatur von Blasformen einer Blasformmaschine (als Beispiel einer Behälterbehandlungsmaschine), so dauert es aufgrund der abzugebenen oder zusätzlich aufzunehmenden Wärme der Blasformen bei Veränderung der Blasformtemperatur länger, bis die Behälterbehandlungsmaschine wieder einen stabilen Zustand eingenommen hat (also die Blasformen sich auf die vorgegebene Temperatur erwärmt oder auf diese abgekühlt haben). Ist der Betriebsparameter eine Temperatur eines Heizelements, wie eines IR-Strahlers oder eines Mikrowellenstrahlers eines Ofens oder sonstigen Heizeinrichtung der Blasformmaschine, so kann ein Einstellen der Temperatur ebenfalls eine längere Zeit benötigen, da ein Abkühlen oder Erwärmen der Heizelemente üblicherweise nicht instantan (also ohne zeitliche Verzögerung) möglich ist. Ist der Betriebsparameter hingegen der Blasdruck, so kann ein stabiler Zustand der Behälterbehandlungsmaschine ggf. sehr schnell bei Änderung des Blasdrucks eingenommen werden, da der Blasdruck im Prinzip ohne zeitliche Verzögerung von einem ersten Wert, der zur Behandlung eines ersten Behälters verwendet wurde, auf einen zweiten Wert zur Behandlung eines zweiten Behälters umgestellt wird. Entsprechend schnell kann beispielsweise auch eine Vorblaszeit anstelle oder zusätzlich zu einem Blasdruck im wesentlichen ohne zeitliche Verzögerung von einem ersten Wert auf einen zweiten Wert eingestellt werden.

Unter der charakteristischen Größe eines Behälters ist grundsätzlich jede Größe zu verstehen, die eine physikalische oder chemische Charakteristik des Behälters definiert. Hierzu zählt beispielsweise die Transparenz oder das Transmissionsverhalten oder das Reflexionsverhalten oder beispielsweise auch der Grad der Verstreckung des Kunststoffmaterials eines blasgeformten Behälters. Auch andere charakteristische Größen können hierunter verstanden werden und die Erfindung ist nicht auf bestimmte charakteristische Größen beschränkt. Da Werte der charakteristischen Größen üblicherweise abhängig von den gewählten Betriebsparametern sind, lässt sich durch Variation der Betriebsparameter und anschließendes Messen der charakteristischen Werte für die mit den jeweiligen Kombinationen von Betriebsparametern behandelten Behälter ableiten, wie die charakteristischen Werte des Behälters beziehungsweise der hergestellten Behälter von der Wahl der Betriebsparameter abhängen.

Wird die Veränderung der Betriebsparameter im Sinne der Erfindung abhängig von ihrer Parameter-Trägheit eingeteilt, so kann die Zeit, die notwendig ist, um alle Kombinationen von Variationen der Betriebsparameter zum Erstellen der digitalen SVP zu durchlaufen, verkürzt werden, da die Variation der Betriebsparameter geordnet abhängig von ihrer Parameter-Trägheit erfolgt. Hiermit kann die digitale SVP bei gleichbleibender Qualität in kürzerer Zeit erstellt werden, was insbesondere die Betriebsdauer und damit auch den Energieaufwand für das Erstellen der SVP reduzieren kann.

Es kann vorgesehen sein, dass die erste Parameter-Trägheit die größte Parameter-Trägheit ist.

Die größte Parameter-Trägheit ist hier als die Parameter-Trägheit des zugehörigen Betriebsparameters zu verstehen, die am größten unter allen Parameter-Trägheiten der Betriebsparameter ist, die zum Erstellen der digitalen SVP variiert werden sollen. Hiermit wird die notwendige Zeit zum Erzeugen der digitalen SVP weiter reduziert.

In einer Ausführungsform ist vorgesehen, dass das Betreiben ein Betreiben mit festen Parameter-Werten aller Betriebsparameter mit einer Parameter-Trägheit, die größer ist als die kleinste Parameter-Trägheit eines der Betriebsparameter, und ein Variieren des oder der Betriebsparameter mit der kleinsten Parameter-Trägheit umfasst.

Mit dieser Ausführungsform kann ein iteratives Verfahren durchgeführt werden, wobei zunächst mit einer Variation des oder der Betriebsparameter begonnen wird, die die kleinste Parameter-Trägheit aufweisen. Anschließend kann dann eine Variation der Betriebsparameter mit der nächstgrößeren Parameter-Trägheit erfolgen und sofort, bis schließlich eine Variation des oder der Betriebsparameter mit größter Parameter-Trägheit erfolgt.

Insbesondere kann vorgesehen sein, dass ein Variieren von Betriebsparametern mit der kleinsten Parameter-Trägheit hin zu Betriebsparametern mit größerer Parameter-Trägheit erfolgt.

Diese Einteilung der Variation der Betriebsparameter in Abhängigkeit ihrer Parameter-Trägheit reduziert die Zeit zum Erzeugen der digitalen SVP weiter.

In einer Ausführungsform ist vorgesehen, dass die charakteristische Größe wenigstens eines von einem Transmissionsverhalten, einem Emissionsverhalten, einer Bruchfestigkeit zumindest eines Teils des Behälters ist.

Diese charakteristischen Größen können insbesondere im Zusammenhang mit Herstellungsmaschinen zum Herstellen von Vorformlingen und/oder Blasformmaschinen durch die verwendeten Betriebsparameter maßgeblich beeinflusst werden. Die basierend auf den Betriebsparametern und diesen charakteristischen Größen erstellte digitale SVP kann daher vorteilhaft genutzt werden, um beispielsweise Blasformverfahren oder Herstellungsverfahren von Vorformlingen zu steuern oder zu regeln.

Es kann vorgesehen sein, dass die Behälterbehandlungsmaschine eine Vorformlingsherstellungsmaschine, eine Blasformmaschine, ein Erwärmungseinrichtung oder ein Füller ist. Die Erwärmungseinrichtung oder Heizeinrichtung kann beispielsweise ein oder mehrere Heizelemente, wie Infrarotstrahler (IR-Strahler) oder Mikrowellenstrahler oder Laseremitter oder beliebige Kombinationen davon umfassen, um Vorformlinge zu erwärmen. Die Heizeinrichtung kann als gerader Tunnel oder mehrstöckiger Tunnel ausgeführt sein, durch den die Vorformlinge transportiert werden können.

Da die Betriebsparameter dieser Maschinen teils sehr großen Einfluss auf die charakteristischen Größen der behandelten Behälter haben können, ist der Einsatz einer digitalen SVP zusammen mit diesen Maschinen besonders vorteilhaft.

Der Betriebsparameter mit der größten Parameter-Trägheit kann eine Temperatur einer Komponente oder eines Betriebsmediums der Behälterbehandlungsmaschine sein. Insbesondere kann es sich bei dem Prozessparameter mit der größten Parameterträgheit um eine Temperatur oder Strahlungsleistung eines Heizelements einer Heizeinrichtung, wie beispielsweise einen IR-Strahler, einen Mikrowellenstrahler oder einen Laseremitter handeln.

Da die notwendige Zeit zum Stabilisieren des Betriebs der Behälterbehandlungsmaschine üblicherweise bei Temperaturänderungen von Komponenten oder Betriebsmedien sehr groß ist, wird mit dieser Ausführungsform die Zeit zum Erstellen der digitalen SVP weiter reduziert, da eine Variation dieses Betriebsparameters seltener erfolgt.

Es kann vorgesehen sein, dass das Verfahren ein Trainieren eines neuronalen Netzes oder eines adaptiven Algorithmus basierend auf den Betriebsparameter-Werten und der charakteristischen Größe zum Erzeugen der digitalen SVP umfasst. Auch andere bekannte Machine Learning Algorithmen können hier verwendet werden.

Unter dem Begriff eines adaptiven Algorithmus ist ein deterministisches Programm oder Algorithmus zu verstehen, der durch Lernprozesse optimiert werden kann. Im Unterschied zu neuronalen Netzen ist jedoch der Output dieses Algorithmus (hier etwa die zu verwendenden Parameterwerte der Betriebsparameter bei bestimmten Soll-Werten der charakteristischen Größen) deterministisch, sodass bei Kenntnis des Input der Output vorhergesagt werden kann. Neuronale Netze werden hingegen üblicherweise als nicht deterministisch oder als "black box" angesehen, da aufgrund ihrer Komplexität eine exakte Vorhersage des Outputs bei Kenntnis des Inputs im Allgemeinen nicht möglich ist.

Neuronale Netze oder adaptive Algorithmen sind besonders vorteilhaft geeignet, um basierend auf einer endlichen Anzahl von Variationen der Betriebsparameter und den dazu ermittelten charakteristischen Größen möglichst genaue Vorhersagen für den Betrieb der Behälterbehandlungsmaschine mit anderen Betriebsparametern zu treffen, sodass eine mit diesen Eigenschaften erzeugte digitale SVP besonders vorteilhaft zum zuverlässigen Betrieb einer Behälterbehandlungsmaschine eingesetzt werden kann.

Das Verfahren kann ein Variieren aller die charakteristische Größe beeinflussender Betriebsparameter zum Erzeugen der digitalen SVP umfassen.

Die so erzeugte digitale SVP bildet das Verhalten der Behälterbehandlungsmaschine bei Variation der Betriebsparameter und den damit einhergehenden Einfluss auf die charakteristischen Größen der zu behandelnden Behälter möglichst zuverlässig ab, sodass ein nachfolgender Betrieb der Behälterbehandlungsmaschine mit dieser digitalen SVP besonders zuverlässig gesteuert oder geregelt werden kann.

Es kann vorgesehen sein, dass ein Variieren eines Betriebsparameters ein Verändern des Betriebsparameters von einem ersten Wert auf einen zweiten Wert und eine anschließende Stabilisierungsphase umfasst, wobei während der Stabilisierungsphase die Behälterbehandlungsmaschine von einem stationären Zustand entsprechend dem ersten Wert in einen stationären Zustand entsprechend dem zweiten Wert übergeht.

Diese Ausführungsform umfasst insbesondere ein Bestimmen der digitalen SVP nur basierend auf Parameterkonstellationen, für die ein stationärer Zustand der Behälterbehandlungsmaschine erreicht wurde. Ein stationärer Zustand der Behälterbehandlungsmaschine ist in diesem Zusammenhang als ein solcher Zustand zu verstehen, in dem sich physikalische Parameter nicht oder nicht mehr wesentlich ändern oder, soweit eine Änderung dieser Parameter vorgesehen ist, diese Änderung so erfolgt wie für den Betrieb angedacht. Dies umfasst beispielsweise, dass sich die Temperatur der Komponenten der Behälterbehandlungsmaschine nach Variation von einem ersten Wert auf einen zweiten Wert auf den zweiten Wert stabilisiert hat oder ein Mediumdruck konstant ist oder dem vorgesehenen zeitlichen Verlauf möglichst exakt entspricht. Mit dieser Ausführungsform wird die Genauigkeit der erzeugten digitalen SVP erhöht.

Die Parameter-Trägheit eines Betriebsparameters kann basierend auf einer Dauer oder einer prognostizierten Dauer der Stabilisierungsphase bestimmt werden.

Die Dauer der Stabilisierungsphase kann beispielsweise gemessen werden, indem Testläufe der Behälterbehandlungsmaschine bei Variation des jeweiligen Betriebsparameters durchgeführt werden. Eine prognostizierte Dauer der Stabilisierungsphase kann beispielsweise anhand von Vergleichswerten anderer Behälterbehandlungsmaschinen oder basierend auf theoretischen Berechnungen zum Verhalten der Behälterbehandlungsmaschine bei Variation der Betriebsparameter bestimmt werden. Die Parameter-Trägheit kann in einer Ausführungsform gleich der Dauer der Stabilisierungsphase sein oder als Funktion der Stabilisierungsphase bestimmt werden
In einer Ausführungsform ist vorgesehen, dass die digitale SVP wenigstens eine Lookup-table, LUT, umfasst, in der Betriebsparameter-Werte wenigstens eines Betriebsparameters jeweils einem Wert der charakteristischen Größe zugeordnet sind..

Lookup-Tables, LUT, und deren Einträge sind mit besonders geringen Abrufkosten innerhalb des Computers verfügbar, sodass die Auswahl geeigneter Betriebsparameter etwa zum Erreichen eines bestimmten Soll-Werts einer charakteristischen Größe eines zu behandelnden Behälters mit dieser digitalen SVP besonders effizient erfolgen kann.

In einer weiteren Ausführungsform ist vorgesehen, dass die digitale SVP ausgebildet ist, basierend auf den verwendeten Betriebsparameter-Werten der Betriebsparameter und der ermittelten charakteristischen Größen bei einer Behälterbehandlung zu verwendende Betriebsparameter-Werte basierend auf einem Soll-Wert der charakteristischen Größe zu extrapolieren.

Durch die Extrapolation mittels der digitalen SVP in nicht während des Erzeugens der digitalen SVP verwendete Bereiche der Betriebsparameter und/oder der charakteristischen Größen kann die Anzahl der während des Erzeugens der digitalen SVP notwendigen Variationen der Betriebsparameter reduziert werden, was die Zeit für das Erstellen der digitalen SVP weiter reduziert.

Erfindungsgemäß ist weiterhin ein Verfahren zum Behandeln eines Behälters mit einer Behälterbehandlungsmaschine vorgesehen, das Verfahren umfassend Betreiben der Behälterbehandlungsmaschine zum Behandeln eines Behälters basierend auf einem Soll-Wert einer charakteristischen Größe des Behälters, wobei wenigstens ein Betriebsparameter der Behälterbehandlungsmaschine mit einer digitalen SVP, die mit einem computer-implementierten Verfahren nach vorangegangenen Ausführungsformen erzeugt wurde, bestimmt wird und das Betreiben der Behälterbehandlungsmaschine mit dem Betriebsparameter durchgeführt wird.

Mit diesem Verfahren ist ein zuverlässiges Behandeln von Behältern möglich.

Erfindungsgemäß ist eine Behälterbehandlungsmaschine zum Behandeln eines Behälters vorgesehen, wobei die Behälterbehandlungsmaschine den Behälter unter Anwendung wenigstens eines einstellbaren Betriebsparameters behandeln kann, wobei die Behälterbehandlungsmaschine eine Steuereinheit mit einer digitalen SVP, die mit einem computer-implementierten Verfahren nach einer der vorangegangenen Ausführungsformen erzeugt wurde, umfasst und wobei die Steuereinheit ausgebildet ist, den wenigstens einen einstellbaren Betriebsparameter unter Verwendung der digitalen SVP basierend auf einem Soll-Wert einer charakteristischen Größe eines zu behandelnden Behälters zu bestimmen und die Behälterbehandlungsmaschine zum Behandeln des Behälters zu steuern.

Mit dieser Behälterbehandlungsmaschine können zuverlässig Behälter mit gewünschten Soll-Werten für charakteristische Größen hergestellt werden.

### Kurze Beschreibung der Figuren

- Figur 1: zeigt ein Fließschema eines computer-implementierten Verfahrens gemäß einer Ausführungsform.
- Figur 2: zeigt ein weiteres Fließschema einer Ausführungsform eines computer-implementierten Verfahrens.
- Figur 3: zeigt eine schematische Ansicht einer Behälterbehandlungsmaschine gemäß einer Ausführungsform.
- Figur 4: zeigt ein Baumdiagramm zur Veranschaulichung des Verfahrens gemäß Figur 2.

### Ausführliche Beschreibung

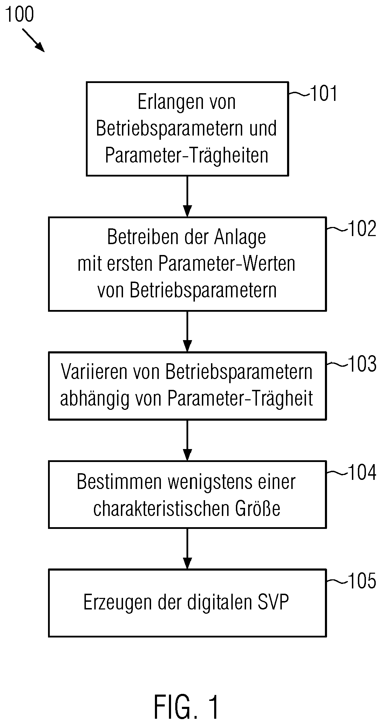

Figur 1, zeigt ein Fließschema eines Verfahrens 100 zum Erzeugen einer digitalen statischen Versuchsplanung, SVP, für eine Behälterbehandlungsmaschine. Der Begriff der Behälterbehandlungsmaschine ist im Sinne der Erfindung zu verstehen als jede Maschine, die eine Interaktion mit einem Behälter und/oder Vorformling durchführen kann, bei der sich bevorzugt zumindest eine charakteristische Größe des Behälters/Vorformlings ändert.

Die digitale SVP wird erfindungsgemäß so erzeugt, dass sie im Betrieb der Behälterbehandlungsmaschine eingesetzt werden kann, um einen Wert eines Betriebsparameters der Behälterbehandlungsmaschine (also den numerischen Wert des Betriebsparameters) basierend auf einem oder mehreren Soll-Werten einer oder mehrerer charakteristischer Größen eines zu behandelnden Behälters vorherzusagen und somit unter Verwendung der digitalen SVP die Behälterbehandlung mit den so vorhergesagten Betriebsparametern erfolgen kann, dass sie nach der Behandlung Werte der charakteristischen Größe oder Größen aufweisen die möglichst den vorgegebenen Soll-Werten entsprechen.

Um dies zu erreichen, wird die digitale SVP erzeugt, indem die Behälterbehandlungsmaschine mit unterschiedlichen Werten und Kombinationen von Werten von Betriebsparametern betrieben wird und die sich daraus ergebenden charakteristischen Größen der zu behandelnden Behälter bestimmt werden. Hieraus lässt sich eine Zuordnung von Kombinationen von Betriebsparametern zu Werten der charakteristischen Größen der mit diesen Betriebsparametern behandelten Behälter erzeugen. Dies erlaubt im nachfolgenden Betrieb durch Verwendung der digitalen SVP eine Vorhersage der charakteristischen Größen der Behälter bei bestimmten Kombinationen von Betriebsparametern. Dabei ist es bevorzugt, wenn die digitale SVP nicht nur für Betriebsparameter und Soll-Werte, basierend auf welchen sie erzeugt wurde, Vorhersagen treffen kann, sondern auch in der Lage ist, in anderen Bereich der Betriebsparameter und/oder Soll-Werte zu extrapolieren, sodass in einem möglichst großen Parameterraum zuverlässige Vorhersagen der Betriebsparameter, die für das Erreichen bestimmter Soll-Werte charakteristischer Größen verwendet werden müssen, möglich sind.

Das Verfahren 100 beginnt mit einem ersten Schritt 101, in dem die für die Erzeugung der digitalen SVP zu berücksichtigenden Betriebsparameter und deren zugehörige Parameter-Trägheiten erlangt werden. Die Betriebsparameter kennzeichnen dabei physikalische und/oder chemische Größen, die für den Betrieb der Behälterbehandlungsmaschine genutzt werden. Dies kann am Beispiel einer Blasformmaschine bswp. der Blasdruck oder das Blasdruckprofil während eines Blasvorgangs oder das Bewegungsprofil einer Reckstange sein. Andere Betriebsparameter betreffen beispielsweise die Temperatur des Blasmediums oder die Temperatur eines Heizelements einer Heizeinrichtung zum Erwärmen der Vorformlinge (wie ein IR-Strahler oder ein Mikrowellenstrahler oder ein Laseremitter) der Blasform oder ähnliches.

Obiges ist nur beispielshaft zu verstehen. Die Erfindung ist hinsichtlich der verwendeten Betriebsparameter nicht beschränkt und ist auch hinsichtlich der Behälterbehandlungsmaschine, für die die digitale SVP erzeugt werden soll, nicht beschränkt. Grundsätzlich ist jedoch vorgesehen, dass zum Erzeugen der digitalen SVP bevorzugt nur solche Betriebsparameter verwendet werden, die einen Einfluss auf die während der Behälterbehandlung zu erzielenden charakteristischen Größen eines Behälters haben. Beispielsweise kann durch die Wahl der Betriebsparameter des Blasvorgangs in gewissem Maße Einfluss auf charakteristische Größen des Behälters, wie beispielsweise das Transmissions- oder Reflexionsverhalten oder den Verstreckungsgrad, genommen werden. Soll mit der digitalen SVP eine Steuerung einer Blasformmaschine zum Einstellen einer dieser charakteristischen Größen möglich sein, so wird die digitale SVP bevorzugt unter Berücksichtigung aller Betriebsparameter der Behälterbehandlungsmaschine erzeugt, die Einfluss auf diese charakteristischen Größen haben können. Darüber hinaus kann vorgesehen sein, dass weitere Betriebsparameter, die auf die charakteristischen Größen keinen Einfluss haben, nicht zum Erzeugen der digitalen SVP berücksichtigt werden.

Die den jeweiligen Betriebsparametern zugeordneten Parameter-Trägheiten sind im Sinne der Erfindung ein Maß für eine Dauer der Antwort der Behälterbehandlungsmaschine auf eine Änderung des jeweiligen Betriebsparameters zu verstehen. Die Dauer der Antwort der Behälterbehandlungsmaschine ist in diesem Sinne beispielsweise eine Dauer einer Stabilisierungsphase der Behälterbehandlungsmaschine nach Veränderung des jeweiligen Betriebsparameters. Die Stabilisierungsphase kann als solche Phase verstanden werden, die von der Behälterbehandlungsmaschine durchlaufen wird, um nach Veränderung eines Wertes eines Betriebsparameters von einem ersten Wert auf einen zweiten Wert einen stationären Zustand anzunehmen. Diese Dauer der Stabilisierungsphase hängt von dem jeweiligen Betriebsparameter ab.

Am Beispiel des für das Ausformen eines Behälters in einer Blasformmaschine verwendeten Blasdrucks ist beispielsweise ersichtlich, dass dieser prinzipiell bei geeigneter Auslegung der Ventile und Schaltungen der Blasformmaschine von einem Behälter auf den nachfolgenden Behälter geändert werden kann, ohne dass es hier beispielsweise zu Abweichungen im zeitlichen Profil des Blastdrucks oder in dessen Höhe kommen. Die Blasformmaschine besitzt somit eine geringe Parameter-Trägheit bezüglich des verwendeten Blastdrucks.

Wird jedoch die Temperatur des Blasmediums, wie etwa Druckluft, oder die Temperatur der Blasformen für den Blasformvorgang verändert, geht hiermit üblicherweise ein Abkühlprozess oder ein Erwärmprozess einer oder mehrerer Komponenten der Blasformmaschine einher. Dies kann nicht instantan erfolgen. Ein Austausch von Wärme ist erforderlich, sodass bspw. ein Wechsel der Blasformtemperatur von einer ersten Temperatur auf eine zweite Temperatur nicht instantan erfolgen kann, sondern beispielsweise ein Aufheizen oder Abkühlen der Blasformen erfordert, was bis zu mehreren Minuten dauern kann. Während dieser Zeit verändert sich die Temperatur der Komponenten der Blasformmaschine (im wesentlichen einem Exponentialgesetz folgend), sodass während dieser Zeit ein Blasformen eines Behälters nicht mit dem vorgesehenen Wert des Betriebsparameters (hier der Blasformtemperatur) erfolgen würde, sondern mit einer zwischen der ersten Temperatur und der zweiten Temperatur liegenden Temperatur erfolgt. Erst wenn genug Zeit verstrichen ist, damit die Blasform auf die gewünschte zweite Temperatur erwärmt oder abgekühlt wurde, hat die Blasformmaschine also den stationären Zustand angenommen.

In diesem Sinne ist die Parameter-Trägheit der Behälterbehandlungsmaschine bezüglich der Blasformtemperatur größer als die Parameter-Trägheit der Blasformmaschine bezüglich einer Veränderung des Blastdrucks. Es versteht sich, dass die Parameter-Trägheit nicht nur von der Art des Betriebsparameters (Temperatur, Druck, etc.) abhängt, sodern ggf. auch von der Größe der Änderung des Betriebsparameters. Dies kann ersichtlich insbesondere bei der Temperatur von Medien oder Komponenten der Fall sein.

Die zum Erzeugen der digitalen SVP zu verwendenden Betriebsparameter sowie deren Trägheiten können beispielsweise in einem Speichermedium hinterlegt sein oder durch Testläufe der Behälterbehandlungsmaschine im Schritt 101 erlangt werden. Dabei können beispielsweise ein oder mehrere Behälter mit einer geringen Anzahl von variierten Betriebsparametern behandelt werden, um festzustellen, ob charakteristische Größen der so behandelten Behälter von den jeweiligen Betriebsparametern abhängen und es kann gleichzeitig oder zusätzlich festgestellt werden, wie lange die Behälterbehandlungsmaschine benötigt, um nach Verändern eines Parameterwertes eines der Betriebsparameter wieder einen stationären Zustand anzunehmen. Hieraus können dann die Parameter-Trägheiten beispielsweise als numerische Werte ermittelt und den jeweiligen Betriebsparametern zugeordnet werden.

In dem sich anschließenden Schritt 202 wird nun die Behälterbehandlungsmaschine mit ersten Parameterwerten von Betriebsparametern betrieben. Beispielsweise kann eine erste Temperatur der Blasform und ein erster Blastdruck verwendet werden. Die mit diesen Betriebsparametern behandelten (in diesem Fall hergestellten) Behälter können dann hinsichtlich ihrer charakteristischen Größen untersucht werden, um so festzustellen, welche Werte der charakteristischen Größen sich bei dieser Kombination von Betriebsparametern ergeben. Dies kann bevorzugt vollautomatisiert erfolgen, indem beispielsweise mithilfe von einer oder mehreren geeigneten Inspektionseinrichtungen die in der Behälterbehandlungsmaschine behandelten Behältern inspiziert werden, um so Werte für die jeweiligen charakteristischen Größen zu ermitteln.

Im Schritt 103 wird dann einer der Betriebsparameter abhängig von der Parameter-Trägheit variiert, also der entsprechende Parameterwert verändert. Dabei ist erfindungsgemäß vorgesehen, dass im Schritt 103 zumindest ein Betriebsparameter mit einer höheren Parameter-Trägheit nicht variiert wird (also festgehalten wird) und zumindest ein Betriebsparameter mit einer geringeren Parameter-Trägheit als diese höhere Parameter-Trägheit variiert wird. Erneut werden die Werte der charakteristischen Größen der Behälter für die nun variierte Kombination von Parameterwerten bestimmt (104). Dabei erfolgt der Schritt 103 erfindungsgemäß bei Festhalten des Betriebsparameters mit der zugeordneten größeren Parameter-Trägheit so häufig, bis alle vorgesehenen Variationen des Betriebsparameters mit der geringeren Parameter-Trägheit durchlaufen wurden.

Die so bestimmten charakteristischen Größen (Schritt 104 und nach Schritt 102) der behandelten Behälter sind dann entsprechend den Kombinationen von variierten Betriebsparametern zugeordnet. Hiermit kann dann auf grundsätzlich bekannte Weise eine digitale SVP erzeugt werden, indem ein für die SVP vorgesehenes Vorhersagemodell mit den erlangten Kombinationen gespeist wird.

Die digitale SVP kann beispielsweise auch als neuronales Netz oder adaptiver Algorithmus ausgeführt sein, sodass durch Durchlaufen der entsprechenden Variationen der Betriebsparameter auf grundsätzlich bekannte Art und Weise Parameter des neuronalen Netzes oder des adaptiven Algorithmus angepasst werden können. Dabei kann beispielsweise eine Vorhersage des neuronalen Netzes oder adaptiven Algorithmus für eine charakteristische Größe eines behandelten Behälters basierend auf der gewählten Kombination von Betriebsparametern mit dem sich tatsächlich ergebenden Wert der charakteristischen Größe bei dieser Kombination von Betriebsparametern verglichen werden und basierend darauf in üblicher Weise ein Training des neuronalen Netzes oder adaptiven Algorithmus erfolgen, bis die Vorhersagegenauigkeit des neuronalen Netzes oder des adaptiven Algorithmus eine gewünschte Genauigkeit, beispielsweise innerhalb bestimmter Grenzen, erreicht.

Anschließend kann ein während des Trainings nicht verwendeter Satz von Kombinationen von Betriebsparametern genutzt werden, um die Vorhersagegenauigkeit des neuronalen Netzes oder des adaptiven Algorithmus oder allgemeiner der digitalen SVP zu überprüfen, indem die vorhergesagten Werte für die eine oder mehreren charakteristischen Größen mit den ermittelten Werten der charakteristischen Größen verglichen werden. Liegt auch hier die Genauigkeit der Vorhersage innerhalb einer beispielsweise vorher festgelegter Toleranzen, so kann das Lernen des neuronalen Netzes oder adaptiven Algorithmus beim Erzeugen der digitalen SVP als beendet angesehen werden und die digitale SVP kann mit dem trainierten neuronalen Netz oder adaptiven Algorithmus im Schritt 105 erzeugt werden.

Da das Bestimmen der charakteristischen Größen für Kombinationen von Betriebsparametern so durchgeführt wird, dass bei Festhalten der Werte von einem Betriebsparameter mit größerer Parameter-Trägheit eine Variation wenigstens eines Betriebsparameters mit geringerer Parameter-Trägheit erfolgt, wird Zeit für die Durchläufe der Behälterbehandlungsmaschine eingespart. Gleichzeitig wird die aufzubringende Energie während des Betriebs der Behälterbehandlungsmaschine reduziert.

Dennoch durchläuft die Behälterbehandlungsmaschine sämtliche vorgesehenen Variationen von Betriebsparametern, sodass die erzeugte digitale SVP eine gleichbleibende Genauigkeit aufweist.

Damit wird eine Möglichkeit zum Erzeugen einer digitalen SVP geschaffen, die bei gleichbleibender Vorhersagegenauigkeit der Betriebsparameter für bestimmte Soll-Werte von charakteristischen Größen eine geringere Zeit zum Erzeugen der digitalen SVP in Anspruch nimmt.

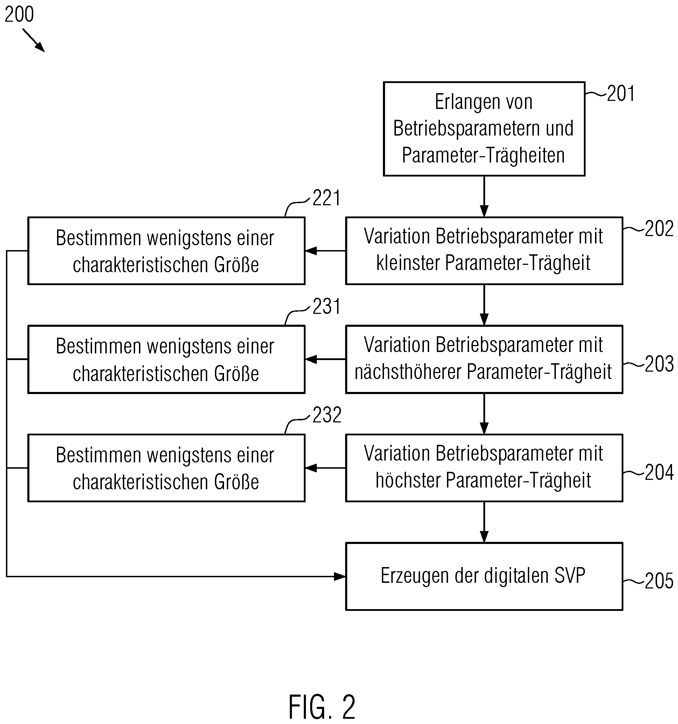

Figur 2 zeigt eine weitere Ausführungsform eines Verfahrens 200 zum Erzeugen einer digitalen SVP. Grundsätzlich sind sämtliche in Bezug auf die Figur 1 beschriebenen Ausführungsformen auch in Verbindung mit der Ausführungsform der Figur 2 anwendbar. Insbesondere kann auch die im Rahmen der Ausführungsform der Figur 2 erzeugte digitale SVP durch Trainieren eines neuronalen Netzes oder adaptiven Algorithmus erlangt werden, oder dies kann ein Teil des Erzeugens der digitalen SVP sein.

Während in der Ausführungsform der Figur 1 bereits eine Reduktion der für das Erzeugen der digitalen SVP notwendigen Betriebszeiten der Behälterbehandlungsmaschine durch Festhalten eines Betriebsparameters mit höherer Parameter-Trägheit und (vollständige) Variation eines Betriebsparameters mit niedriger Parameter-Trägheit erreicht wurde, erfolgt in der Ausführungsform der Figur 2 eine vollständige Ordnung und Variation der Betriebsparameter abhängig von den zugehörigen Parameter-Trägheiten, sodass die Betriebsdauer der Behälterbehandlungsmaschine und damit die Zeit für das Erzeugen der digitalen SVP noch weiter reduziert wird.

Analog zur Figur 1 werden im ersten Schritt 201 des Verfahrens zunächst die zu variierenden Betriebsparameter und die zugehörigen Parameter-Trägheiten erlangt.

Anschließend wird die Variation der Betriebsparameter derart vorgenommen, dass Variation der Betriebsparameter ihrer Parameter-Trägheit nach aufsteigend erfolgt, sodass mit der Variation des oder der Betriebsparameter mit der kleinsten Parameter-Trägheit im Schritt 202 begonnen wird.

In diesem Schritt 202 werden sämtliche Betriebsparameter mit höherer Parameter-Trägheit festgehalten, also auf einem festgegebenen Wert belassen und nur der oder die Betriebsparameter mit der kleinsten Parameter-Trägheit variiert. Die zu den jeweiligen Betriebsparametern gehörenden gemessenen charakteristischen Größen werden im Schritt 221 bestimmt, wie dies im Zusammenhang mit der Figur 1 bereits beschrieben wurde.

Im nächsten Schritt 203 erfolgt dann eine Variation des oder der Betriebsparameter mit nächst höherer Parameter-Trägheit, während die Betriebsparameter mit noch höherer Parameter-Trägheit festgehalten werden. Im Schritt 203 können auch die Betriebsparameter mit kleinerer Parameter-Trägheit festgehalten werden oder diese werden zusammen mit den Betriebsparametern mit nächst höherer Parameter-Trägheit variiert, um eventuelle mehrdimensionale Einflüsse der Variationen verschiedener Betriebsparameter auf die charakteristische Größe oder die charakteristischen Größen des zu behandelnden Behälters abbilden zu können.

Erneut werden im Schritt 231 während der Variation der Betriebsparameter im Schritt 203 die zugehörigen charakteristischen Größen der behandelten Behälter ermittelt.

Dieses Verfahren wird sukzessive mit einer Variation von Betriebsparametern mit ansteigender Parameter-Trägheit durchgeführt, bis im Schritt 204 eine Variation der Betriebsparameter mit der höchsten Parameter-Trägheit erfolgt. Auch hier kann vorgesehen sein, dass bei einer Variation bzw. Veränderung des Betriebsparameters mit höchster Parameter-Trägheit von einem ersten Wert auf einen zweiten Wert eine Variation sämtlicher Betriebsparameter mit niedrigerer Parameter-Trägheit bei festgehaltenem Betriebsparameter mit höchster Parameter-Trägheit erfolgt, um auch die Beeinflussung der charakteristischen Größen durch Veränderung der Betriebsparameter korrekt abzubilden.

Analog zu den Schritten 221 und 231 werden auch in diesem Teil des Verfahrens die charakteristische Größe oder die charakteristischen Größen der behandelten Behälter bestimmt.

Anhand der so bestimmten Kombinationen von Betriebsparametern und charakteristischen Größen der mit diesen Betriebsparametern behandelten Behälter wird dann im Schritt 205 die digitale SVP erzeugt, wie dies auch bereits im Zusammenhang mit der Figur 1 beschrieben wurde.

Während vorgesehen sein kann, dass eine Ordnung der Betriebsparameter nach ihrer Parameter-Trägheit so erfolgt, dass eine Variation nur solcher Betriebsparameter mit gleich Parameter-Trägheit in einem Schritt des Verfahrens durchgeführt wird, kann auch vorgesehen sein, dass Betriebsparameter mit gleich oder nur annähernd gleicher Parameter-Trägheit variiert werden. Beispielsweise kann vorgesehen sein, dass Betriebsparameter entsprechend ihrer Parameter-Trägheit zu Gruppen zusammengefasst werden, wobei eine Gruppe beispielsweise alle Betriebsparameter mit einer Parameter-Trägheit umfassen kann, die um weniger als beispielsweise 10% des Mittelwertes der Parameter-Trägheit der Gruppe abweichen. Auch andere Kriterien für die Zusammenfassung von Betriebsparametern zu Gruppen basierend auf ihrer Parameter-Trägheit sind möglich.

Das Verfahren entsprechend der Ausführungsform der Figur 2 wird dann so durchgeführt, dass eine Variation von Betriebsparametern einer Gruppe durchgeführt wird, wohingegen die Betriebsparameter der übrigen Gruppen mit höherer Parameter-Trägheit festgehalten werden.

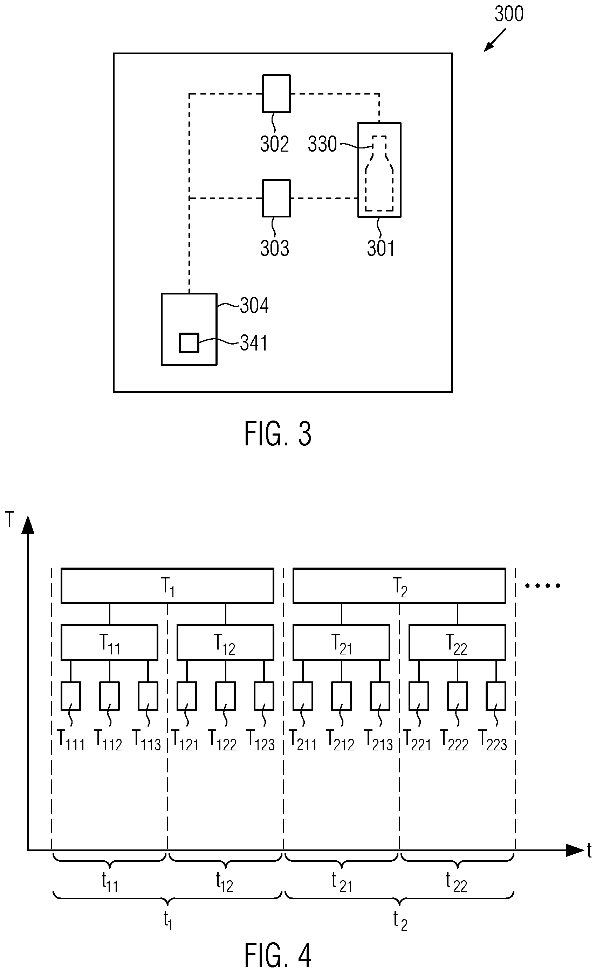

Figur 3 zeigt schematisch eine Ausführungsform einer Behälterbehandlungsmaschine 300 am Beispiel einer Blasformmaschine. Die Ausführungsform ist schematisch und dient dem besseren Verständnis.

Die Blasformmaschine 300 umfasst wenigstens eine, bevorzugt eine Vielzahl von Blasformen 301. Diese sind zum Betrieb der Blasformmaschine mit weiteren Komponenten 302 und 303 (Anzahl hier nur beispielhaft) verbunden. Bei den Komponenten 302 und 303 kann es sich beispielsweise um Heizeinrichtungen für die Blasform 301 und/oder eine Reckstange und/oder eine Medienzufuhr für ein Blasmedium handeln. Der Blasformprozess ist durch Betriebsparameter und deren Parameterwert gekennzeichnet und kann beispielsweise eine bestimmte Temperatur der Blasform 301 und damit beispielsweise des zugeordneten Heizelements 302 sowie ein Bewegungsprofil der Reckstange 303 umfassen.

Diese Parameter haben Einfluss auf das Ergebnis des Blasformprozesses, indem sie beispielsweise Einfluss auf den Transmissionsgrad oder Reflexionsgrad des blasgeformten Behälters oder den Verstreckungsgrad des PET-Materials des blasgeformten Behälters nehmen.

Die Blasformmaschine 300 umfasst weiterhin eine Steuereinheit 304, die beispielsweise als Computer mit zugeordnetem Speicher ausgeführt sein kann und bevorzugt ausgebildet ist, die Komponenten 301, 302 und 303 der Blasformmaschine 300 zu steuern, sodass diese mit bestimmten Parameterwerten für die jeweiligen Betriebsparameter betrieben werden können, um einen Behälter 330 mit der Blasformmaschine 300 aus einem Vorformling herzustellen. Diese Verfahren sind grundsätzlich bekannt. Dabei können verschiedene Komponenten oder Bestandteile der Blasformmaschine, wie etwa Heizelemente oder einzelne Blasformen auch mit unterschiedlichen Betriebsparametern betrieben werden, während die digitale SVB erstellt wird und die Betriebsparameter der Komponenten können varriert werden. So kann beispielsweise gezielt das individuelle Verhalten einer Blasform und der ihr zugeordneten Komponenten oder eines Heizstrahlers beim Erstellen der SVP berücksichtigt werden.

Gemäß einer Ausführungsform umfasst die Steuereinheit 304 eine digitale SVP 341, die entsprechend einem der vorangegangenen Verfahren erzeugt wurde. Im Betrieb der Blasformmaschine 300 können der Steuereinheit 304 beispielsweise durch einen Bediener bestimmte Werte für eine oder mehrere charakteristische Größen der auszuformenden Behälter vorgegeben werden. Beispielsweise kann ein Transmissionsgrad des auszuformenden Behälters vorgegeben werden. Die Steuereinheit kann dann durch Verwendung der digitalen SVP basierend auf dem oder den Soll-Werten für die charakteristische(n) Größe(n) der Behälter die zu verwendenden Betriebsparameter für die Komponenten der Blasformmaschine bestimmen und die Blasformmaschine abhängig von den zu realisierenden Soll-Werten der herzustellenden Behälter steuern.

Hiermit wird die Notwendigkeit des Eingriffs eines Bedieners zum Festlegen der Betriebsparameter der Blasformmaschine reduziert und gleichzeitig die Genauigkeit mit der die Einstellung der Betriebsparameter der Blasformmaschine zum Erhalten von Behältern mit Werten der charakteristischen Größen, die den Soll-Werten möglichst nahe kommen, verbessert.

Um das Verfahren gemäß Figur 2 weiter anschaulich zu erklären zeigt Figur 4 ein Baumdiagramm zur Veranschaulichung des Variierens der Betriebsparameter entsprechend ihrer Parameter-Trägheit.

Im Baumdiagramm sind zusätzlich zwei Achsen, eine Trägheitsachse T für eine Parameter-Trägheit, sowie eine Zeitachse t eingezeichnet.

Das Verfahren beginnt zu einem beliebigen Zeitpunkt mit dem Festlegen eines ParameterWertes für einen Betriebsparameter mit der größten Parameter-Trägheit T₁. Diese Entsprechend Figur 2 wird nun für einen Betriebsparameter mit einer geringeren Parameter-Trägheit ein Wert festgelegt, hier zunächst T₁₂. Anschließend wird ein Parameter-Wert T₁₁₁ für einen Betriebsparameter mit noch geringerer Parameter-Trägheit festgelegt. Das Baumdiagramm umfasst in dieser Ausführungsform drei verschiedene Parameter-Trägheits-Stufen von größter Parameter-Trägheit (eine Ziffer als Index) zu niedrigster Parameter-trägheit (drei Ziffern als Index).

Während der Parameter-Wert T₁ nun für einen Zeitraum t₁ konstant gehalten wird, wird zunächst für einen Zeitraum t₁₁, in dem zusätzlich der Parameter-Wert T₁₂ festgehalten wird, der Parameter-Wert des Betriebsparameters mit niedrigster Parameter-Trägheit variiert von dem Wert T₁₁₁ über T₁₁₂ bis zu T₁₁₃. Während hier drei Variationsschritte eingezeichnet sind, versteht es sich, dass auch mehr oder weniger möglich sind.

Anschließend wird der Parameter-Wert von T₁₁ auf T₁₂ verändert. Über einen Zeitraum t₁₂ wird dieser Wert festgehalten und die Parameter-Werte eines Betriebsparameters mit geringerer Parameter-Trägheit variiert (hier die Werte T₁₂₁, T₁₂₂, T₁₂₃).

Dieses Verfahren wird iterativ so oft durchgeführt, bis alle Variationen des Betriebsparameters mit der zweithöchsten Parameter-Trägheit durchlaufen wurden (hier der Betriebsparameter mit zwei Ziffern als Index). Anschließend und somit nach der Zeit t₁ wird der Parameter-Wert des Betriebsparameters mit der größten Parameter-Trägheit von T₁ auf T₂ verändert. Über den Zeitraum t₂, während dem T₁ konstant gehalten wird, werden nun Betriebsparameter mit niedrigerer Parameter-Trägheit variiert. Dies erfolgt analog zum Zeitraum t₁. Der Parameter-Wert des Betriebsparameters mit nächst-geringerer Parameter-Trägheit wird zunächst auf den Wert T₂₁ festgesetzt. Über den Zeitraum t₂₁ werden die Betriebsparameter mit noch geringerer Parameter-Trägheit variiert (Werte T₂₁₁, T₂₁₂, T₂₁₃). Anschließend wird der Wert des Betriebsparameters mit nächst-niedriger Parameter-Trägheit auf den Wert T₂₂ gesetzt und über den Zeitraum t₂₂ werden die Betriebsparameter mit noch geringerer Parameter-Trägheit variiert (Werte T₂₂₁, T₂₂₂, T₂₂₃).

Bei jeder der im Zusammenhang mit Figur 4 beschriebenen Variationen von Parameter-Werten werden dann die charakteristischen Größen entsprechend der Figur 2 bestimmt und zum Erzeugen der digitalen SVP verwendet.

Hiermit kann zeitsparend die digitale SVP erzeugt werden, da Variationen für Betriebsparameter mit höherer Parameter-Trägheit möglichst selten verändert werden. Gleichzeitig wird die SVP mit hoher Genauigkeit erstellt, da dennoch alle notwendigen Variationen durchlaufen werden können.

## Patentansprüche

1. Computer-implementiertes Verfahren zum Erzeugen einer digitalen statischen Versuchsplanung, SVP, einer Behälterbehandlungsmaschine, wobei die digitale SVP einen Wert eines Betriebsparameters der Behälterbehandlungsmaschine basierend auf einem Soll-Wert einer charakteristischen Größe eines zu behandelnden Behälters vorhersagen kann, das Verfahren umfassend:
- Erlangen einer Parameter-Trägheit für Betriebsparameter der Behälterbehandlungsmaschine;
- Betreiben der Behälterbehandlungsmaschine mit einem festen Betriebsparameter-Wert eines ersten Betriebsparameters mit einer ersten Parameter-Trägheit und Variieren wenigstens eines zweiten Betriebsparameters mit einer kleineren zweiten Parameter-Trägheit als der ersten Parameter-Trägheit;
- Bestimmen wenigstens einer charakteristischen Größe eines behandelten Behälters abhängig von dem Betriebsparameter-Wert des ersten Betriebsparameters und den Betriebsparameter-Werten des zweiten Betriebsparameters;
- Erzeugen der digitalen SVP basierend auf den Betriebsparameter-Werten und der charakteristischen Größe.

2. Computer-implementiertes Verfahren nach Anspruch 1, wobei die erste Parameter-Trägheit die größte Parameter-Trägheit ist.

3. Computer-implementiertes Verfahren nach Anspruch 1 oder 2, wobei das Betreiben ein Betreiben mit festen Parameter-Werten aller Betriebsparameter mit einer Parameter-Trägheit, die größer ist als die kleinste Parameter-Trägheit eines der Betriebsparameter, und ein Variieren des oder der Betriebsparameter mit der kleinsten Parameter-Trägheit umfasst.

4. Computer-implementiertes Verfahren nach Anspruch 3, wobei ein Variieren von Betriebsparametern mit der kleinsten Parameter-Trägheit hin zu Betriebsparametern mit größerer Parameter-Trägheit erfolgt.

5. Computer-implementiertes Verfahren nach einem der Ansprüche 1 bis 4, wobei die charakteristische Größe wenigstens eines von einem Transmissionsverhalten, einem Emissionsverhalten, einer Bruchfestigkeit zumindest eines Teils des Behälters ist.

6. Computer-implementiertes Verfahren nach einem der Ansprüche 1 bis 5, wobei die Behälterbehandlungsmaschine eine Vorformlingsherstellungsmaschine, eine Blasformmaschine oder ein Füller ist.

7. Computer-implementiertes Verfahren nach einem der Ansprüche 1 bis 6, wobei der Betriebsparameter mit der größten Parameter-Trägheit eine Temperatur einer Komponente oder eines Betriebsmediums der Behälterbehandlungsmaschine ist.

8. Computer-implementiertes Verfahren nach einem der Ansprüche 1 bis 7, wobei das Verfahren ein Trainieren eines neuronalen Netzes oder eines adaptiven Algorithmus basierend auf den Betriebsparameter-Werten und der charakteristischen Größe zum Erzeugen der digitalen SVP umfasst.

9. Computer-implementiertes Verfahren nach einem der Ansprüche 1 bis 8, wobei das Verfahren ein Variieren aller die charakteristische Größe beeinflussender Betriebsparameter zum Erzeugen der digitalen SVP umfasst.

10. Computer-implementiertes Verfahren nach einem der Ansprüche 1 bis 9, wobei ein Variieren eines Betriebsparameters ein Verändern des Betriebsparameters von einem ersten Wert auf einen zweiten Wert und eine anschließende Stabilisierungsphase umfasst, wobei während der Stabilisierungsphase die Behälterbehandlungsmaschine von einem stationären Zustand entsprechend dem ersten Wert in einen stationären Zustand entsprechend dem zweiten Wert übergeht.

11. Computer-implementiertes Verfahren nach Anspruch 10, wobei die Parameter-Trägheit eines Betriebsparameters basierend auf einer Dauer oder einer prognostizierten Dauer der Stabilisierungsphase bestimmt wird.

12. Computer-implementiertes Verfahren nach einem der Ansprüche 1 bis 11, wobei die digitale SVP wenigstens eine Lookup-table, LUT, umfasst, in der Betriebsparameter-Werte wenigstens eines Betriebsparameters jeweils einem Wert der charakteristischen Größe zugeordnet sind.

13. Computer-implementiertes Verfahren nach einem der Ansprüche 1 bis 12, wobei die digitale SVP ausgebildet ist, basierend auf den verwenden Betriebsparameter-Werten der Betriebsparameter und der ermittelten charakteristischen Größen bei einer Behälterbehandlung zu verwendende Betriebsparameter-Werte basierend auf einem Soll-Wert der charakteristischen Größe zu extrapolieren.

14. Verfahren zum Behandeln eines Behälters mit einer Behälterbehandlungsmaschine, das Verfahren umfassend Betreiben der Behälterbehandlungsmaschine zum Behandeln eines Behälters basierend auf einem Soll-Wert einer charakteristischen Größe des Behälters, wobei wenigstens ein Betriebsparameter der Behälterbehandlungsmaschine mit einer digitalen SVP, die mit einem computer-implementierten Verfahren nach einem der Ansprüche 1 bis 13 erzeugt wurde, bestimmt wird und das Betreiben der Behälterbehandlungsmaschine mit dem Betriebsparameter durchgeführt wird.

15. Behälterbehandlungsmaschine zum Behandeln eines Behälters, wobei die Behälterbehandlungsmaschine den Behälter unter Anwendung wenigstens eines einstellbaren Betriebsparameters behandeln kann, wobei die Behälterbehandlungsmaschine eine Steuereinheit mit einer digitalen SVP, die mit einem computer-implementierten Verfahren nach einem der Ansprüche 1 bis 13 erzeugt wurde, umfasst und wobei die Steuereinheit ausgebildet ist, den wenigstens einen einstellbaren Betriebsparameter unter Verwendung der digitalen SVP basierend auf einem Soll-Wert einer charakteristischen Größe eines zu behandelnden Behälters zu bestimmen und die Behälterbehandlungsmaschine zum Behandeln des Behälters zu steuern.
